(19) Europäisches Patentamt / European Patent Office / Office européen des brevets

(11) **EP 3 914 658 B1**

(12) **EUROPEAN PATENT SPECIFICATION**

(45) Date of publication and mention
of the grant of the patent:
**23.08.2023  Bulletin 2023/34**

(21) Application number: **19700908.7**

(22) Date of filing: **15.01.2019**

(51) International Patent Classification (IPC):
**C09D 11/322** *(2014.01)*    **C09D 11/36** *(2014.01)*
**C09D 11/38** *(2014.01)*    **H01K 3/10** *(2006.01)*

(52) Cooperative Patent Classification (CPC):
**C09D 11/322; C09D 11/36; C09D 11/38;
H10K 30/00; H10K 50/11;** H10K 71/135;
Y02E 10/549

(86) International application number:
**PCT/EP2019/050966**

(87) International publication number:
**WO 2020/147940 (23.07.2020 Gazette 2020/30)**

(54) **INK FORMULATION FOR INKJET PRINTING OF TIO2 ACTIVE LAYERS**

TINTENFORMULIERUNG FÜR DEN TINTENSTRAHLDRUCK VON TIO2-AKTIVEN SCHICHTEN

FORMULATION D'ENCRE POUR IMPRESSION À JET D'ENCRE DE COUCHES ACTIVES DE TIO2

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**01.12.2021  Bulletin 2021/48**

(73) Proprietor: **Toyota Motor Europe
1140 Brussels (BE)**

(72) Inventors:
• **KINGE, Sachin
1140 BRUSSELS (BE)**

• **HUCKABA, Aron J.
1015 LAUSANNE (CH)**
• **NAZEERUDDIN, Mohammad Khaja
1015 LAUSANNE (CH)**

(74) Representative: **Cabinet Beau de Loménie
158, rue de l'Université
75340 Paris Cedex 07 (FR)**

(56) References cited:
**CN-A- 108 922 970      US-A1- 2012 111 409
US-A1- 2016 104 843**

**Description**

Field of the Invention

The present invention is in the field of materials for optoelectronic applications and in particular solar cells and light emitting diodes (LEDs).

Background to the Invention

In the technical field of optoelectronic devices, it is often required to prepare thin films of semiconducting materials. This is because creating films of uniform property and thickness is crucial for applications for large-area and flexible devices. The industrially scalable methods of spray coating, ink jet printing can be applied for this purpose but appropriate inks are needed.

Inkjet printing is a material-conserving deposition technique used for liquid inks, which consist of a material to be deposited, dissolved or dispersed in a solvent. The inkjet printing process consists in ejecting a given amount of ink in a chamber from a nozzle via piezoelectric action. The ejected drop falls on a substrate and spreads, and then dries through solvent evaporation. Inkjet printing offers a possibility of direct imaging, and thus provides more flexibility in designing optoelectronic devices.

Among several semiconducting materials, perovskites have received a lot of attention in recent years due to their flexibility, low weight and low cost.

Perovskites $RMX_3$ (wherein R is an organic group such as methyl, butyl, phenyl etc., M are metal cations of Pb, Cs, and X are halide ions such as I, Cl, Br) are materials that are important for solar cells, LEDs and several optoelectronic applications, since these materials can be prepared as 2D or 3D materials. These materials have so far been used as bulk materials.

In high performance perovskite solar cell devices, $TiO_2$ is used as the electron transport material or electron selective contact that transports electrons to the anode. This material is deposited using spin-coating deposition methods and so far there is no method to inkjet-print this material for high efficiency devices.

Cherrington et al. ([1]) discloses inkjet-printing of $TiO_2$, wherein the ink is composed of 14% DMF, 26% water and 25% PEG-400, 3% $TiO_2$ nanoparticles and 3% dispersant.

Bernacka-Wojciket al. ([2]) discloses inkjet-printing of $TiO_2$, wherein the ink is composed of 87% of ethanol, 5% of ethylene glycol, 5% of $TiO_2$ and 3% of dispersant.

US 2012/0111409 discloses semiconductor oxide ink compositions for inkjet printing, containing a semiconductor oxide such as $TiO_2$ and a solvent such as a mixture of water and ethanol. US 2016/0104843 discloses a titanium oxide paste prepared using ethyl cellulose, lauric acid and terpineol. CN 108922970 discloses $TiO_2$ and $ZrO_2$ slurries prepared using ethyl cellulose and terpineol.

Non-Patent Literature References

> [1] Energy Technol. 2015, 3, 866-870
> [2] J. Colloid and interface Science, 2016, 465, 208-214

Summary of the Invention

The present invention aims at providing a composition which enables one to create films of uniform property and thickness, and to ensure reproducible fabrication of high quality $TiO_2$ films outside of a glovebox and in ambient conditions, as well as stable inkjet printing at a variety of cartridge and substrate temperatures, from 21 °C to 50 °C, reducing the "coffee ring" effect upon ink drying/concentration.

The present ink formulation is intended for reproducible fabrication of high quality $TiO_2$ films using scalable processing techniques, which has been a problem for previous reports of inkjet-printed perovskite films.

In one aspect, the present invention relates to a composition comprising:

   (A) a titania source comprising:
   (A1) $TiO_2$ particles; and
   (B) a solvent mixture comprising:

      (B1) cyclopentanol and/or cyclohexanol;

(B2) poly ethylene glycol, poly propylene glycol, poly(vinyl)alcohol, poly(vinyl)pyrrolidone, ethylcellulose or a mixture thereof; and

(B3) an N,N-dialkylamide, an alkyl sulfoxide or a mixture thereof.

The present invention also relates to a method for inkjet-printing the composition of the present invention, as well as its use and a solar cell comprising the composition of the present invention.

In another aspect, the present invention relates to a method of inkjet-printing comprising the following steps:

(1) printing the composition of the invention on a substrate to obtain a printed film;
(2) optionally dipping the printed film obtained in step (1) in an anti-solvent, to obtain a dipped film; and
(3) annealing the dipped film obtained in step (2).

In still another aspect, the present invention relates to a use of the composition according to the present invention.

In still another aspect, the present invention relates to a solar cell wherein the composition according to the present invention and a composition comprising perovskite precursors are inkjet-printed.

Brief Description of the Figures

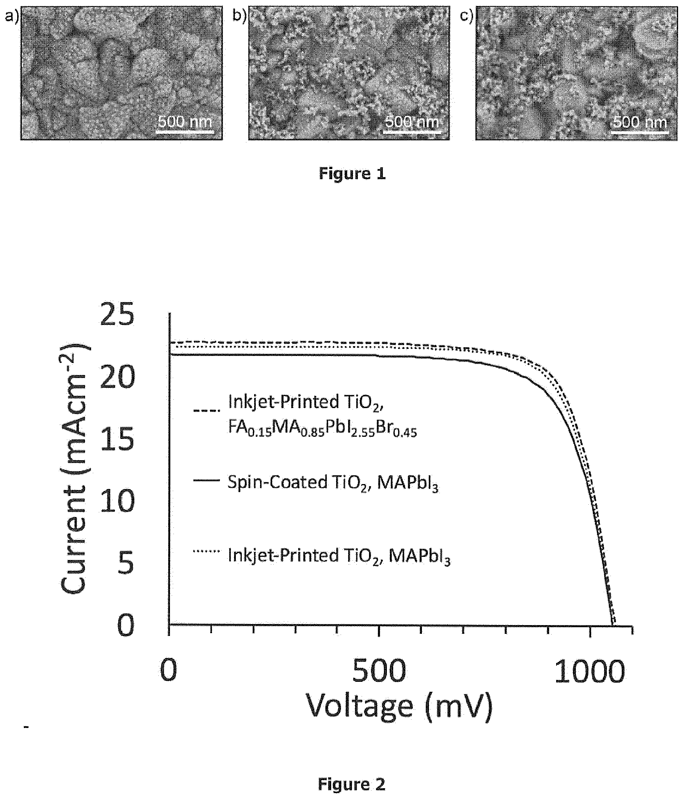

Figure 1 presents scanning electron micrograph image of different film morphologies: a) spray-pyrolysis deposited compact $TiO_2$ (no particles) b) mesoporous $TiO_2$ films deposited by inkjet printing (showing 30 nm nanoparticles) and c) mesoporous/compact hybrid $TiO_2$ films deposited by inkjet printing with TAA additive (showing 5 nm and 30 nm nanoparticles).

Figure 2 presents J-V (current-voltage) curves, showing the fill factor, Jsc, and Voc of the devices, of cells using a) spin-coated $TiO_2$ and $MAPbI_3$, b) inkjet-printed mesoporous $TiO_2$ and $MAPbI_3$ and c) inkjet-printed $(FA_{0.15}MA_{0.85})Pb(I_{2.55}Br_{0.45})$.

Figure 3 presents a J-V curve of the best-performing cell with both inkjet-printed $TiO_2$ and inkjet-printed perovskite layers. The cell was illuminated with 100 mWcm$^{-2}$ of a simulated solar spectrum.

Figure 4 presents a schematic structure of a typical solar cell, using both $TiO_2$ and perovskite layers. Here, IJP stands for inkjet-printed.

Detailed Description of the Invention

<Definitions>

The term "organic-inorganic hybrid perovskites", as used herein, refers to $ABX_3$ materials with A = cation groups such as methylammonium (MA), butylammonium (BA), formamidinium (FA), Cs, and their mixtures; M is a metal such as Pb, Sn, Bi, Cu, Ag and their mixtures; and X are halides such as Cl, Br, I and their mixtures. Layered perovskites contain additional bulkier molecules such as phenethylamine (PEA) or phenyethylammonium, hexylammonium (HA) and longer chain ammonium species, which confine different perovskite domains into different repeating units. Specific examples given here comprise inorganic metal-halide multi-layered perovskites. These examples are nonlimiting.

The term "antisolvent", as used herein, refers to a solvent which precipitates the perovskite intermediate complex and induces nucleation while removing excess solvent. An anti-solvent treatment consists in, for example, introducing a volume of an anti-solvent, such as toluene, ethyl acetate, chlorobenzene, or ethyl ether onto the wet/drying/dry perovskite precursor film to supersaturate the precursor film and quickly induce nucleation and remove excess solvent to produce smooth perovskite films.

<Ink composition>

One aspect of the present invention relates to a composition comprising:

(A) a titania source comprising:
(A1) $TiO_2$ particles; and
(B) a solvent mixture comprising:

(B1) cyclopentanol and/or cyclohexanol;
(B2) poly ethylene glycol, poly propylene glycol, poly(vinyl)alcohol, poly(vinyl)pyrrolidone, ethylcellulose or a mixture thereof; and

(B3) an N,N-dialkylamide, an alkyl sulfoxide or a mixture thereof.

<Titania source (A)>

<$TiO_2$ particules (A1)>

The composition of the present invention comprises $TiO_2$ particles (A1).

$TiO_2$ particles (A1) used in the composition of the present invention are not particularly limited.

Preferably, $TiO_2$ particles (A1) can be selected from the group consisting of dense, compact, textured, smooth, mesoporous, or amorphous $TiO_2$ particles.

More preferably, the $TiO_2$ particles are selected from the group consisting of mesoporous, textured, compact $TiO_2$ particles.

In a particularly preferred embodiment, the $TiO_2$ particles are mesoporous $TiO_2$ particles.

The particle size of (A1) is 10 nm or more and 50 nm or less, preferably 20 nm or more and 40 nm or less and more preferably 25 nm or more and 35 nm or less, and most preferably about 30 nm, wherein the particle size is as measured by scanning electronic microscopy (SEM).

When the particle size of $TiO_2$ particles is in the above range, charge collection is better.

In one preferred embodiment, the titania may have a formula of $TiO_2$.

If the titania is sub-stoichiometric, this is generally seen as deleterious for device functioning, but slightly extra oxygen should not be a large problem.

In another preferred embodiment, the titania may be doped with a metallic or non-metallic elements such as the first and second row elements, transiton metals, and main group elements. Almost every element can be doped into titania.

In a preferred embodiment, $TiO_2$ particles comprise 30 nm particles and 2-10 nm particles, with the small particles grown from molecular precursors in the ink, which improves charge collection.

<$TiO_2$ precursors (A2)>

The composition may further comprise one or more $TiO_2$ precursors (A2).

$TiO_2$ precursors (A2) used in the composition of the present invention are not particularly limited.

Preferably $TiO_2$ precursors (A2) can be selected from a group consisting of titanium bis(acetylacetone) diisopropoxide, titanium isopropoxide, titanium ethoxide, and titanium tetrachloride bis tetrahydrofuran.

More preferably $TiO_2$ precursors (A2) is titanium bis(acetylacetone) diisopropoxide, since it is stable enough for ink storage and can be printed reliably.

< Linear alcohol, alicyclic alcohol, benzyl alcohol or mixture thereof (B1)>

In the composition of the present invention, (B1) is selected from cyclopentanol, cyclohexanol and mixtures thereof.

The (B1), such as cyclohexanol, is viscous, somewhat polar, and has a good surface tension.

< Alicyclic alcohol (B1)>

Alicyclic alcohol (B1) used in the composition of the present invention is cyclehexanol and/or cyclopentanol.

<Poly ethylene glycol, poly propylene glycol, poly(vinyl)alcohol, poly(vinyl)pyrrolidone, ethylcellulose or a mixture thereof (B2)>

(B2) used in the composition of the present invention is not particularly limited.

In a preferred embodiment, (B2) has a molecular weight of 200 Da or more and 1000 Da or less, preferably of 250 Da or more and 600 Da or less, and more preferably 300 Da or more and 500 Da or less.

Preferably, (B2) is PEG-400, which acts as humectant, viscosity modifier, and density enhancer.

< N,N-dialkylamide, alkyl sulfoxide or mixture thereof (B3)>

(B3) used in the composition of the present invention is not particularly limited.

(B3) can be selected from the group consisting of N,N-dimethylformamide, N,N-diethylformamide, N,N-dimethylacetamide and N,N-diethylacetamide, lactams such as N-alkyl lactams and alkyl sulfoxides such as dimethyl sulfoxides, ethylmethyl sulfoxide, diethyl sulfoxide and mixtures thereof.

Preferably, (B3) is N,N-dimethylformamide, which has high polarity and surface tension and thus allows good drying after printing.

<Alkyl sulfoxide (B4)>

The present composition may further comprise an alkyl sulfoxide (A4).

Alkyl sulfoxide (B4) is selected from the group consisting of dimethyl sulfoxide, cyclic or linear dialkyl sulfoxide, such as dimethyl sulfoxide, ethylmethyl sulfoxide, diethyl sulfoxide and other derivatives.

Preferably, alkyl sulfoxide (B4) is dimethyl sulfoxide.

It has been found that device performance can be enhanced with an alkyl sulfoxide.

<Combination of (B1), (B2) and (B3) >

Preferably, (B1) is cyclohexanol, (B2) is PEG-400, and (B3) is N, N-dimethylformamide. In such a case, good drying with proper surface tension, proper density, proper viscosity, and humectant properties can be assured.

<Relative amount of (A1), (B1), (B2) and (B3) >

In terms of the relative amounts of (A1), for the total weight amount of the composition summing to 100% by weight, the weight amount of (A1) is preferably comprised between 0.323 % and 0.418 %:

$$0.323 \leq \frac{\text{weight of (A1)}}{\text{total weight of the composition}} * 100 \leq 0.418$$

In one preferred embodiment, for the total weight amount of the composition summing to 100% by weight, the weight amount of (A1) is 0.399%.

$$\frac{\text{weight of (A1)}}{\text{total weight of the composition}} * 100 = 0.399$$

When the amount of (A1) is comprised in the above range, this will allow good formation of open $TiO_2$ pores.

In terms of the relative amounts of the four solvents (B1), (B2) and (B3), for a total amount of added volume of solvents (B1), (B2) and (B3) summing to 100% by volume, the amount of (B1) is preferably 58% by volume or more and 68% by volume or less, the amount of (B2) is preferably 16% by volume or more and 26% by volume or less, and the amount of (B3) is preferably 11% by volume or more and 21% by volume or less:

$$58 \leq \frac{volume\ of\ (B1)}{sum\ of\ the\ volume\ of\ (B1), (B2)\ and (B3)} * 100 \leq 68$$

$$16 \leq \frac{volume\ of\ (B2)}{sum\ of\ the\ volume\ of\ (B1), (B2)\ and\ (B3)} * 100 \leq 26$$

$$11 \leq \frac{volume\ of\ (B3)}{sum\ of\ the\ volume\ of\ (B1), (B2)\ and\ (B3)} * 100 \leq 21$$

When the amount of (B1) is comprised in the above range, this will allow good formation of open $TiO_2$ pores.

More preferably, for a total amount of added volume of solvents (B1), (B2) and (B3) summing to 100% by volume, the amount of (B1) is 61% by volume or more and 65% by volume or less, the amount of (B2) is 19% by volume or more and 23% by volume or less, and the amount of (B3) is 14% by volume or more and 18% by volume or less:

$$61 \leq \frac{(B1)}{sum \ othe \ volume \ of \ (B1), (B2) \ and \ (B3)} * 100 \leq 65$$

$$19 \leq \frac{(B2)}{sum \ of \ the \ volume \ of \ (B1), (B2) \ and \ (B3)} * 100 \leq 23$$

$$14 \leq \frac{(B3)}{sum \ of \ the \ volume \ of \ (B1), (B2) \ and \ (B3)} * 100 \leq 18$$

When the amount of (B1), (B2) and (B3) is comprised in the above range, this will allow good formation of open TiO$_2$ pores.

In one preferred embodiment, for a total amount of added volume of solvents (B1), (B2) and (B3) summing to 100% by volume, the amount of (B1) is 60% by volume, the amount of (B2) is 20% by volume, and the amount of (B3) is 15% by volume.

$$\frac{(B1)}{sum \ of \ all \ the \ liquids \ to \ be \ mixed} * 100 = 60$$

$$\frac{(B2)}{sum \ of \ all \ the \ liquids \ to \ be \ mixed} * 100 = 20$$

$$\frac{(B3)}{sum \ of \ all \ the \ liquids \ to \ be \ mixed} * 100 = 15$$

When the amount of (B1), (B2) and (B3) is comprised in the above range, this will allow very good formation of open TiO$_2$ pores.

In one particularly preferred embodiment, (B1) is cyclohexanol, (B2) is PEG-400 and (B3) is N,N-dimethylformamide, and the volume ratio between (B1), (B2) and (B3) is 60 : 20 : 15.

<Other additive>

<Dispersant (C)>

The present composition may further comprise a dispersant (C) selected from any non-ionic dispersant such as TWEEN, polidocanol, decyl polyglucose, glycerol monostrearate, monolaurin, stearyl alcohol, polyoxamer.

The amount of (C) is not particularly limited.

Preferably, the amount of the dispersant (C) is 0.001% to 5% by volume, for the total amount of the composition summing to 100% by volume.

In one preferred embodiment, the amount of the dispersant is 0.8% by volume, for the total amount of the composition summing to 100% by volume.

<Method of inkjet printing>

One aspect of the present invention relates to a method of inkjet printing comprising the following steps:

(1) printing the composition as set out above on a substrate to obtain a printed film;
(2) optionally, dipping the printed film obtained in step (1) in an anti-solvent, to obtained a dipped film; and
(3) annealing the dipped film obtained in step (2).

<Substrate>

The substrate can be selected from the group consisting of metal-oxide semiconductors such as ZnO, TiO$_2$,

$SnO_2$, Al-doped ZnO (AZO), $NiO_x$, vanadium oxide, $SiO_2$, $Al_2O_3$, Si, graphene; and other 2D transition metal chalcogenides, such as $MoS_2$, $MeSe_2$, $FeS_2$, $VS_2$; glass coated with fluorine doped tin oxide, glass titanium dioxide surfaces on glass.

<Inkjet printing (1)>

The inkjet-printing step can be realized by using a printing machine appropriate for inkjet-printing.
For example, Dimatix 2831, Dimatix 2850, Ceradrop inkjet printer, commercially available, can be used for inkjet-printing.

<Anti-solvent treatment (2)>

An optional anti-solvent treatment consists in dipping the printed film obtained in step (1) in an anti-solvent.
The anti-solvent can be any organic solvent.
Preferably, the anti-solvent can be selected from the group consisting of benzene, substituted benzenes, such as toluene, fluorobenzene, chlorobenzene, bromobenzene, iodobenzene, toluene, xylene, mesitylene, ethyl acetate, ethyl propionate, metyl propionate, ethyl ether, diethyl ether, propyl ether, butyl ether, pentane, hexane, heptane, cyclohexane, cycloheptane, octane and octene.
Preferably, the anti-solvent is selected from the group consisting of diethyl ether, ethyl acetate, toluene, and hexane.

<Annealing (3)>

In one particular embodiment, anti-solvent treatment step (3) is carried out in an ambient atmosphere, at 120°C, for 30 seconds to 1 minute.
In a preferred embodiment, the method of inkjet-printing further comprises the following step (4) after step (3):
(4) spray-depositing a solution or dispersion comprising perovskite precursors selected from the group consisting of MAI, $PbI_2$, MABr, $PbBr_2$, MACl, $PbCl_2$, PEAI, PEABr, PEACl, CsI, $SrCl_2$, $CaCl_2$, KI, CsBr, CsCl, NaCl, NaI, GUAI, GUABr, GUACl, FAI, FABr, FACl wherein MA stands for methylammonium, PEA for phenylethylammonium, GUA for guanidinium, and FA for formamidinium.

<Film processing>

In the film processing, the film is transported from the platen of the inkjet printer to the anti-solvent bath for some time, then placed on a hotplate set to 120° C.

<Technical effect of the present invention

By using the composition of the present invention, it is possible to create films of uniform property and thickness, and to ensure reproducible fabrication of high quality $TiO_2$ films outside of a glovebox and in ambient conditions, as well as stable inkjet-printing at a variety of cartridge and substrate temperatures, from 21°C to 50°C, reducing the "coffee ring" effect upon ink drying/concentration. The present ink composition also has concentration flexibility: $TiO_2$ can be dispersed at a variety of concentrations from 0.323 to 0.418 % by weight, for the total amount of the composition summing to 100% by weight. Such concentration flexibility facilitates its application in inkjet-printing. The present ink composition is further compatible with anti-solvent treatment.

<Applications>

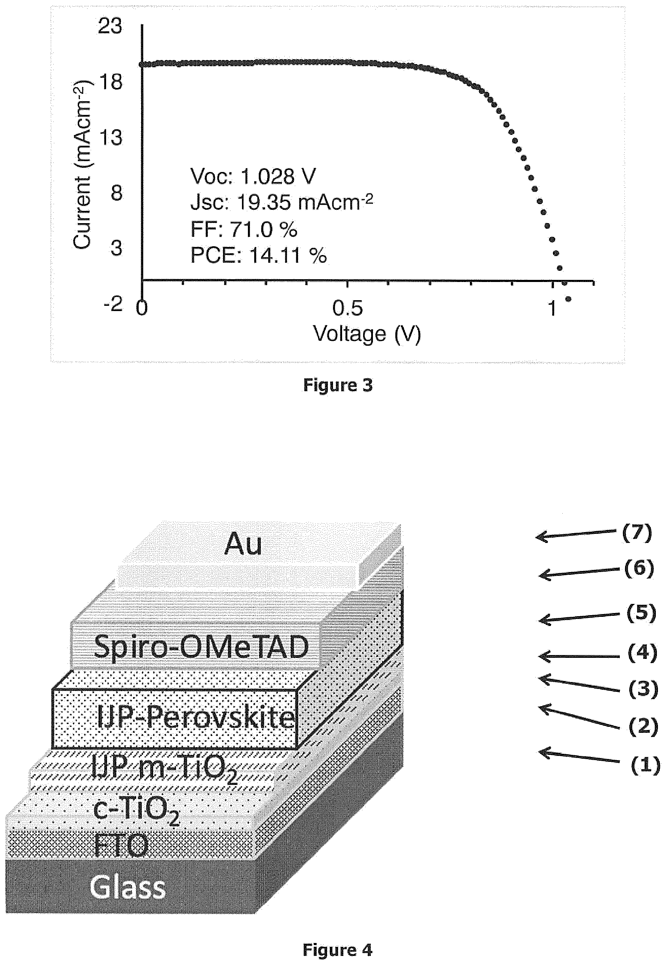

The present composition can be used in inkjet printing, especially, in order to produce an optoelectronic device, and more specifically, in order to produce a solar cell or a light emitting diode (LED).
As shown in Figure 4, a solar cell can comprise a substrate layer (in Figure 4, a glass substrate is used), a transparent conducting film layer (in Figure 4, fluorine-doped tin oxide (FTO) is used), an electron extraction layer (a spray coated compact $TiO_2$ (in Figure 4, c-$TiO_2$) layer is used), an electron transport layer (in Figure 4, an inkjet-printed mesoporous $TiO_2$ (m-$TiO_2$) layer is used), a spin-coated hole transport material (in Figure 4, spiro-OMeTAD is used), and an electrode (in Figure 4, a thermally evaporated Au layer is used).
In advantageous embodiments of the present application, the perovskite inkjet printing ink composition is based on a binary solvent mixture comprising:

(A) at least one perovskite precursor(s); and
(B) a mixture of solvents comprising:

(B1) a lactone, an ester or a carbonate; and
(B2) a linear N,N-dialkylamide.

The composition may further comprise lactam (B3), which is preferably is selected from the group consisting of N-alkyl lactams, and preferably is N-methylpyrrolidone.

For a total amount of added volume of solvents (B1), (B2), (B3) and (B4) summing to 100% by volume, the amount of (B1) is preferably28% by volume or more and 43% by volume or less, the amount of (B2) is 28% by volume or more and 43% by volume or less, the amount of (B3) is 0.001% by volume or more and 15% by volume or less and the amount of (B4) is 0% by volume or more and 33% by volume or less:

$$28 \leq \frac{volume\ of\ (B1)}{sum\ of\ the\ volume\ of\ (B1),(B2),(B3)\ and\ (B4)} * 100 \leq 43$$

$$28 \leq \frac{volume\ of\ (B2)}{sum\ of\ the\ volume\ of\ (B1),(B2),(B3)\ and\ (B4)} * 100 \leq 43$$

$$0.001 \leq \frac{volume\ of\ (B3)}{sum\ of\ the\ volume\ of\ (B1),(B2),(B3)\ and\ (B4)} * 100 \leq 15$$

$$0 \leq \frac{volume\ of\ (B4)}{sum\ of\ the\ volume\ of\ (B1),(B2),(B3)\ and\ (B4)} * 100 \leq 33$$

and more preferably, for a total amount of added volume of solvents (B1), (B2), (B3) and (B4) summing to 100% by volume, the amount of (B1) is 30% by volume or more and 40% by volume or less, the amount of (B2) is 30% by volume or more and 40% by volume or less, the amount of (B3) is 0.01% by volume or more and 10% by volume or less and the amount of (B4) is 26% by volume or more and 30% by volume or less:

$$30 \leq \frac{volume\ of\ (B1)}{sum\ of\ the\ volume\ of\ (B1),(B2),(B3)\ and\ (B4)} * 100 \leq 40$$

$$30 \leq \frac{volume\ of\ (B2)}{sum\ of\ the\ volume\ of\ (B1),(B2),(B3)\ and\ (B4)} * 100 \leq 40$$

$$0.01 \leq \frac{volume\ of\ (B3)}{sum\ of\ the\ volume\ of\ (B1),(B2),(B3)\ and\ (B4)} * 100 \leq 10$$

$$26 \leq \frac{volume\ of\ (B4)}{sum\ of\ the\ volume\ of\ (B1),(B2),(B3)\ and\ (B4)} * 100 \leq 30$$

Examples

**1) Ink Synthesis:**

**1)-1: Preparation of perovskite ink**

The following starting materials were mixed to prepare an ink composition:

0.417 mL gamma-butyrolactone;
0.062 mL N-methylpyrrolidone;
0.352 mL dimethyl sulfoxide;
0.417 mL N,N'-dimethylformamide;
with $PbI_2$ (1.15 mmol, 0.53 g), FAI (1.033 mmol, 0.177 g), $PbBr_2$ (0.19 mmol, 0.071 g), MABr (0.18 mmol, 0.020 g), CsI (0.115 mmoln 0.02988 g), GuI (0.063 mmol, 0.012 g), and phosphatidylcholine (0.001 g)

The solvents are added to the dry powder chemicals in each case.

The obtained ink composition comprised 0.9 M of Pb precursors.

The solvent in the anti-solvent bath is diethyl ether, and the film is wet after printing and dry after the bath and before heat treatment.

A high performance ink was obtained with 0.6 M $PbI_2$, 0.6 M methylammonium iodide, and 0.2 M methylammonium chloride in the previously mentioned solvent blend.

## 1)-2: Preparation of $TiO_2$ ink

PEG-400 (0.20 mL), cyclohexanol (0.65 mL), N,N-dimethylformamide (0.15 mL), and TWEEN-60 (0.008 g) and GreatCell Solar Italia-NRT 30 $TiO_2$ paste (0.028 g), comprising 19% by weight (i.e. 0.00532 g) of $TiO_2$ particles, were mixed, sonicated, and stirred at room temperature until thoroughly mixed. The suspension was then filtered with a 1.2 $\mu$m filter.

A $TiO_2$ ink formulation was prepared as a ternary solvent blend with proportions of 60% cyclohexanol, 20% PEG-400, 15% DMF, 2.1% $TiO_2$ paste, 2.1% titanium bis(acetylacetonate) diisopropoxide solution, 0.8% dispersant.

## 2) Device fabrication

## 2)-1: Substrate Preparation before printing $TiO_2$

Electrode preparation with compact $TiO_2$: Chemically etched FTO glass (Nippon Sheet Glass) was sequentially cleaned by sonication in a 2 % Helmanex solution, deionized water, acetone and isopropanol for 8 min each. To form a 30 nm thick $TiO_2$ blocking layer, titanium di-isopropoxide bis(acetylacetonate) (TAA, 75% in isopropanol) solution (Sigma-Aldrich) diluted in ethanol 3% (v/v) was deposited by spray pyrolysis at 450 °C.

## 2)-2: Inkjet printing of mesoporous $TiO_2$

The $TiO_2$ ink was added to a disposable Dimatix (DMP-2800) 1.5 mL printer cartridge of nominally 10 pL jetted droplet volume and containing 16 nozzles (21 $\mu$m orifice) and nozzle spacing of 254 $\mu$m. The cartridge head was warmed to 70°C and the substrate was warmed to 35°C. After printing, the substrate was warmed to 100°C for 10 min and then baked at 500°C for 30 min. The annealed substrates were then scored with glass scorer/cutter to yield 1.35 × 2.35 $cm^2$ areas.

The ink was printed on a thin layer of titanium dioxide which was deposited on fluorine-doped tin oxide deposited on a glass substrate.

When fabricating spin-coated perovskite layers on these electrodes, the substrate was broken along the scored lines. When inkjet-printing the perovskite layer on these electrodes, the substrate was not broken along the scored lines until the perovskite was deposited.

## 2)-3: $TiO_2$ film processing

For $TiO_2$ film processing, the printed ink is allowed to dry at room temperature for a period of time of minutes to hours, then annealed on a hot plate up to 500 °C.

Room-temperature drying followed by thermal annealing was then carried out at 500 °C for round 90 nm. It is dried before the perovskite ink is added during the thermal annealing step mentioned previously.

## 2)-4 (A): Inkjet-printing of perovskite

The perovskite ink was loaded into a disposable Dimatix (DMP-2800) 1.5 mL printer cartridge of nominally 10 pL jetted droplet volume and containing 16 nozzles (21 $\mu$m orifice) and nozzle spacing of 254 $\mu$m. The cartridge head and substrate were not warmed prior to printing. Once printed, the wet film was immersed in diethylether for 5-10 s, removed, and annealed at 120 °C in ambient conditions.

The ink was used in a Fujifilm Dimatix DMP printer with a 16 nozzle printhead, 21 micron spacing between nozzles at a cartridge temperature of 45 °C. The ink formulation allows for stable printing and reduces coffee ring effect upon ink drying/concentration.

### 2)-4 (B): Perovskite Deposition by spin-coating:

Mixed-perovskite precursor was prepared by mixing 1.15 M $PbI_2$, 1.10 M FAI, 0.2 M $PbBr_2$, 0.2 M MABr in a mixed solvent of DMF:DMSO = 4:1 (volume ratio). Mixed perovskite solutions were successively spin-coated in the glovebox as follows: first, 2000 rpm for 10 s with a ramp-up of 200 $rpm \cdot s^{-1}$; second, 6000 rpm for 30 s with a ramp-up of 2000 $rpm \cdot s^{-1}$. Toluene (110 $\mu l$) was dropped on the spinning substrate during the second spin-coating step 20 s before the end of the procedure. Then films were annealed at 100°C for 90 min.

The pure $MaPbI_3$ precursor solution contained 1.3 M $PbI_2$ and 1.3 M MAI in anhydrous DMSO. The perovskite films were prepared by spin-coating on the substrates at 1000 rpm for the first 10 s and 4000 rpm for the following 30 s. Chlorobenzene (0.1 mL, CB) was slowly dropped on the film 10 s before the spin-coating program finished, then the samples were heated at 100°C for 1 hour.

### 2)-5: Perovskite film processing

For perovskite film processing, the wet ink is submerged in an anti-solvent bath for a period of time of seconds to minutes and then the dry film is annealed on a hot plate at 120 °C.

After printing the perovskite precursor ink, the films were dipped in anti-solvent bath of diethyl ether, then dried, and annealed in ambient atmosphere at 120 °C for 30s -1 min.

### 2)-6: Hole Transport Material (HTM) Deposition and gold evaporation

HTM solution (40 $\mu L$) containing 91 mg Spiro-OMeTAD and additives (21 $\mu L$ of Li-bis(trifluoromethanesulfonyl)imide from a stock solution of 520 mg in 1 mL of acetonitrile, 16 $\mu L$ of FK209, tris(2-(1H-pyrazol-1-yl)-4-tert-3 butylpyridine)-cobalt(III) tris(bis(trifluoromethylsulfonyl)imide from a stock solution of 375 mg in 1 mL of acetonitrile, and 36 $\mu L$ of 4-tertbutylpyridine in 1 mL of CB was spin-coated on the samples at 4000 rpm for 20 s, and followed by the evaporating Au electrode with thickness of 70 nm.

### Photovoltaic Characterization

The photovoltaic performance was analyzed using a VeraSol LED solar simulator (Newport) coupled with a Keithley 2400 source/meter giving light with AM 1.5G (100 $W/cm^2$) spectral distribution. A black mask with an aperture 0.16 $cm^2$ was applied on top of the cell. The light intensity was calibrated with an NREL certified KG5 filtered Si reference diode.

Table 1 presents photovoltaic performance of perovskite solar cells utilizing inkjet-printed mesoporous $TiO_2$ layers and spin-coated perovskite films under 100 $mW \cdot cm^{-2}$ simulated solar irradiation. Each value is an average of measurements from at least two devices. For these cells, drop spacing = 30 $\mu m$, passes = two. Asterisk denotes reference devices.

Table 1

| Entry | Substrate Temperature (°C) | Perovskite | $J_{SC}$ (mAcm$^{-2}$) | $V_{OC}$ (mV) | FF (%) | PCE (%) |
|---|---|---|---|---|---|---|
| 1 | n/a | $MAPbI_3$ | 21.70* | 1050* | 74.0* | 16.91* |
| 2 | 45 | $MaPbI_3$ | 21.75 | 1080 | 67.0 | 15.63 |
| 3 | 60 | $MaPbI_3$ | 22.27 | 1050 | 76.0 | 17.78 |
| 5 | 45 | $FA_{0.15}MA_{0.85}PbI_{2.55}Br_{0.45}$ | 21.09 | 1042 | 69.5 | 15.26 |
| 6 | 60 | $FA_{0.15}MA_{0.85}PbI_{2.55}Br_{0.45}$ | 22.65 | 1058 | 76.3 | 18.29 |

## Claims

1. Composition comprising:

(A) a titania source comprising:
(A1) TiO$_2$ particles; and
(B) a solvent mixture comprising:

(B1) cyclopentanol, cyclohexanol or a mixture thereof;
(B2) polyethylene glycol, polypropylene glycol, poly(vinyl)alcohol, poly(vinyl)pyrrolidone, ethylcellulose or a mixture thereof; and
(B3) an N,N-dialkylamide, an alkyl sulfoxide or a mixture thereof.

2. Composition according to claim 1, wherein the particle size of (A1) is 10 nm or more and 50 nm or less, preferably 20 nm or more and 40 nm or less and more preferably 25 nm or more and 35 nm or less, and most preferably about 30 nm, wherein the particle size is measured by scanning electronic microscopy (SEM).

3. Composition according to claim 1 or 2, wherein the (A1) is mesoporous anatase.

4. Composition according to any one of claims 1 to 3, wherein (B2) is polyethylene glycol and/or polypropylene glycol.

5. Composition according to any one of claims 1 to 4, wherein (B2) has a molecular weight of 200 Da or more and 1000 Da or less, preferably of 250 Da or more and 600 Da or less, and more preferably 300 Da or more and 500 Da or less.

6. Composition according to any one of claims 1 to 5, wherein (B2) is PEG-400.

7. Composition according to any one of claims 1 to 6, wherein (B3) is selected from the group consisting of N,N-dimethylformamide, N,N-diethylformamide, N,N-dimethylacetamide and N,N-diethylacetamide, lactams such as N-alkyl lactams and alkyl sulfoxides such as dimethyl sulfoxides, ethylmethyl sulfoxide, diethyl sulfoxide and mixtures thereof, and preferably N,N-dimethylformamide.

8. Composition according to any one of claims 1 to 7, wherein the composition further comprises one or more TiO$_2$ precursors (A2), preferably selected from a group consisting of titanium bis(acetylacetone) diisopropoxide, titanium isopropoxide, titanium ethoxide, titanium titanium tetrachloride bis tetrahydrofuran, and more preferably titanium bis(acetylacetone) diisopropoxide.

9. Composition according to any one of claims 1 to 8, wherein, for the total weight amount of the composition summing to 100% by weight, the weight amount of (A1) is comprised between 0.323 % and 0.418 %:

$$0.323 \leq \frac{\text{weight of (A1)}}{\text{total weight of the composition}} * 100 \leq 0.418$$

10. Composition according to any one of claims 1 to 9, wherein, for the total amount of added (B1), (B2) and (B3) summing to 100% by volume, the amount of (B1) is 58% by volume or more and 68% by volume or less, the amount of (B2) is 16% by volume or more and 26% by volume or less, and the amount of (B3) is 11% by volume or more and 21% by volume or less:

$$58 \leq \frac{volume\ of\ (B1)}{sum\ of\ the\ volume\ of\ (B1), (B2)\ and (B3)} * 100 \leq 68$$

$$16 \leq \frac{volume\ of\ (B2)}{sum\ of\ the\ volume\ of\ (B1), (B2)\ and\ (B3)} * 100 \leq 26$$

$$11 \leq \frac{volume\ of\ (B3)}{sum\ of\ the\ volume\ of\ (B1), (B2)\ and\ (B3)} * 100 \leq 21$$

preferably, the amount of (B1) is 61% by volume or more and 65% by volume or less, the amount of (B2) is 19% by volume or more and 23% by volume or less, and the amount of (B3) is 14% by volume or more and 18% by volume or less:

$$61 \leq \frac{(B1)}{sum\ othe\ volume\ of\ (B1), (B2)\ and\ (B3)} * 100 \leq 65$$

$$19 \leq \frac{(B2)}{sum\ of\ the\ volume\ of\ (B1), (B2)\ and\ (B3)} * 100 \leq 23$$

$$14 \leq \frac{(B3)}{sum\ of\ the\ volume\ of\ (B1), (B2)\ and\ (B3)} * 100 \leq 18$$

11. Method of inkjet-printing comprising the following steps:

   (1) printing the composition according to any one of claims 1 to 10 on a substrate to obtain a printed film;
   (2) optionally, dipping the printed film obtained in step (1) in an anti-solvent, to obtain a dipped film; and
   (3) annealing the dipped film obtained in step (2).

12. Method of inkjet-printing according to claim 11, further comprising the following step (4) after step (3):
   (4) spray-depositing a solution comprising perovskite precursors selected from the group consisting of MAI, $PbI_2$, MABr, $PbBr_2$, MACl, $PbCl_2$, PEAI, PEABr, PEACl, CsI, $SrCl_2$, $CaCl_2$, KI, CsBr, CsCl, NaCl, NaI, GUAI, GUABr, GUACl, FAI, FABr, FACl wherein MA stands for methylammonium, PEA for phenylethylammonium, GUA for guanidinium, and FA for formamidinium;

13. Method according to claim 11 or 12, wherein the substrate is selected from the group consisting of metal-oxide semiconductors such as ZnO, $TiO_2$, $SnO_2$, Al-doped ZnO (AZO), $NiO_x$, vanadium oxide, $SiO_2$, $Al_2O_B$, Si, graphene; and other 2D transition metal chalcogenides such as $Mos_2$, $MoSe_2$, $VS_2$, $FeS_2$; glass coated with fluorine doped tin oxide, glass titanium dioxide surfaces on glass.

14. Method according to any one of claims 11 to 13, wherein the anti-solvent is selected from the group consisting of diethyl ether, ethyl acetate, toluene, and hexane.

15. Method according to any one of claims 11 to 14, wherein step (3) is carried out in an ambient atmosphere, preferably at 150°C, for 1 to 3 minutes.

16. Use of the composition according to any one of claims 1 to 10 in inkjet printing.

17. Use according to claim 16, in order to produce an optoelectronic device.

18. Use according to claim 16 or 17, in order to produce a solar cell or a light emitting diode (LED).

19. A solar cell wherein the composition according to any one of claims 1 to 10 and a composition comprising perovskite precursors are inkjet-printed.

20. A solar cell comprising, according to claim 19, in the following order:

   - a glass substrate (1);
   - a coating layer (2) of fluorine-doped tin oxide or indium doped tin oxide;
   - a thin layer of spray-coated $TiO_2$ layer (3);
   - an inkjet-printed $TiO_2$ layer (4) of the composition according to any one of claims 1 to 9;
   - an inkjet-printed perovskite layer (5);
   - a spin-coated hole transport material layer (6);and
   - a thermally evaporated gold layer (7).

**Patentansprüche**

1.  Zusammensetzung, umfassend:

    (A) eine Titanquelle, umfassend:
    (A1) $TiO_2$-Partikel; und
    (B) ein Lösungsmittelgemisch, umfassend:

    (B1) Cyclopentanol, Cyclohexanol oder ein Gemisch davon;
    (B2) Polyethylenglykol, Polypropylenglykol, Poly(vinyl)alkohol, Poly(vinyl)pyrrolidon, Ethylcellulose oder ein Gemisch davon; und
    (B3) ein N,N-Dialkylamid, ein Alkylsulfoxid oder ein Gemisch davon.

2.  Zusammensetzung nach Anspruch 1, wobei die Partikelgröße von (A1) 10 nm oder mehr und 50 nm oder weniger, bevorzugt 20 nm oder mehr und 40 nm oder weniger und noch bevorzugter 25 nm oder mehr und 35 nm oder weniger und am bevorzugtesten etwa 30 nm beträgt, wobei die Partikelgröße mittels Rasterelektronenmikroskopie (REM) gemessen wird.

3.  Zusammensetzung nach Anspruch 1 oder 2, wobei es sich bei dem (A1) um mesoporöses Anatas handelt.

4.  Zusammensetzung nach einem der Ansprüche 1 bis 3, wobei es sich bei (B2) um Polyethylenglykol und/oder Polypropylenglykol handelt.

5.  Zusammensetzung nach einem der Ansprüche 1 bis 4, wobei (B2) ein Molekulargewicht von 200 Da oder mehr und 1000 Da oder weniger, bevorzugt von 250 Da oder mehr und 600 Da oder weniger und noch bevorzugter 300 Da oder mehr und 500 Da oder weniger aufweist.

6.  Zusammensetzung nach einem der Ansprüche 1 bis 5, wobei es sich bei (B2) um PEG-400 handelt.

7.  Zusammensetzung nach einem der Ansprüche 1 bis 6, wobei (B3) ausgewählt ist aus der Gruppe bestehend aus N,N-Dimethylformamid, N,N-Diethylformamid, N,N-Dimethylacetamid und N,N-Diethylacetamid, Lactamen wie etwa N-Alkyllactamen und Alkylsulfoxiden wie etwa Dimethylsulfoxiden, Ethylmethylsulfoxid, Diethylsulfoxid und Gemischen davon, und bevorzugt N,N-Dimethylformamid.

8.  Zusammensetzung nach einem der Ansprüche 1 bis 7, wobei die Zusammensetzung ferner eine oder mehrere $TiO_2$-Vorstufen (A2), die bevorzugt ausgewählt sind aus einer Gruppe bestehend aus Titan-bis(acetylaceton)diisopropoxid, Titanisopropoxid, Titanethoxid, Titantetrachlorid-bis-tetrahydrofuran, und noch bevorzugter Titan-bis(acetylaceton)diisopropoxid umfasst.

9.  Zusammensetzung nach einem der Ansprüche 1 bis 8, wobei bezogen auf die Gesamtgewichtsmenge der Zusammensetzung, die sich auf 100 Gewichts-% beläuft, die Gewichtsmenge von (A1) zwischen 0,323 % und 0,418 % liegt:

$$0{,}323 \leq \frac{\text{Gewicht von (A1)}}{\text{Gesamtgewicht der Zusammensetzung}} * 100 \leq 0{,}418$$

10. Zusammensetzung nach einem der Ansprüche 1 bis 9, wobei bezogen auf die Gesamtmenge an zugegebenem (B1), (B2) und (B3), die sich auf 100 Volumen-% beläuft, die Menge an (B1) 58 Volumen-% oder mehr und 68 Volumen-% oder weniger beträgt, die Menge an (B2) 16 Volumen-% oder mehr und 26 Volumen-% oder weniger beträgt und die Menge an (B3) 11 Volumen-% oder mehr und 21 Volumen-% oder weniger beträgt:

$$58 \leq \frac{Volumen\ von\ (B1)}{Summe\ des\ Volumens\ von\ (B1),(B2)\ und\ (B3)} * 100 \leq 68$$

$$16 \leq \frac{Volumen\ von\ (B2)}{Summe\ des\ Volumens\ von\ (B1),(B2)\ und\ (B3)} * 100 \leq 26$$

$$11 \leq \frac{Volumen\ von\ (B3)}{Summe\ des\ Volumens\ von\ (B1), (B2)\ und\ (B3)} * 100 \leq 21$$

bevorzugt die Menge an (B1) 61 Volumen-% oder mehr und 65 Volumen-% oder weniger beträgt, die Menge an (B2) 19 Volumen-% oder mehr und 23 Volumen-% oder weniger beträgt und die Menge an (B3) 14 Volumen-% oder mehr und 18 Volumen-% oder weniger beträgt:

$$61 \leq \frac{(B1)}{Summe\ des\ Volumens\ von\ (B1), (B2)\ und (B3)} * 100 \leq 65$$

$$19 \leq \frac{(B2)}{Summe\ des\ Volumens\ von\ (B1), (B2)\ und (B3)} * 100 \leq 23$$

$$14 \leq \frac{(B3)}{Summe\ des\ Volumens\ von\ (B1), (B2)\ und (B3)} * 100 \leq 18$$

**11.** Verfahren zum Tintenstrahldrucken, umfassend die folgenden Schritte:

(1) Bedrucken eines Substrats mit der Zusammensetzung nach einem der Ansprüche 1 bis 10, um einen aufgedruckten Film zu erhalten;
(2) gegebenenfalls Eintauchen des in Schritt (1) erhaltenen aufgedruckten Films in ein Antilösungsmittel, um einen eingetauchten Film zu erhalten; und
(3) Anlassen des in Schritt (2) erhaltenen eingetauchten Films.

**12.** Verfahren zum Tintenstrahldrucken nach Anspruch 11, ferner umfassend den folgenden Schritt (4) nach Schritt (3):
(4) Sprühabscheiden einer Lösung, umfassend Perowskit-Vorstufen, die ausgewählt sind aus der Gruppe bestehend aus MAI, PbI$_2$, MABr, PbBr$_2$, MACl, PbCl$_2$, PEAI, PEABr, PEACl, CsI, SrCl$_2$, CaCl$_2$, KI, CsBr, CsCl, NaCl, NaI, GUAI, GUABr, GUACl, FAI, FABr, FACl, wobei MA für Methylammonium steht, PEA für Phenylethylammonium, GUA für Guanidin und FA für Formamidin steht;

**13.** Verfahren nach Anspruch 11 oder 12, wobei das Substrat ausgewählt ist aus der Gruppe bestehend aus Metall-Oxid-Halbleitern wie etwa ZnO, TiO$_2$, SnO$_2$, Aldotiertem ZnO (AZO), NiOx, Vanadiumoxid, SiO$_2$, Al$_2$O$_3$, Si, Graphen; und anderen 2D-Übergangsmetall-Chalkogeniden wie etwa Mos$_2$, MoSe$_2$, VS$_2$, FeS$_2$; mit fluordotiertem Zinnoxid beschichtetem Glas, Glastitandioxidflächen auf Glas.

**14.** Verfahren nach einem der Ansprüche 11 bis 13, wobei das Antilösungsmittel ausgewählt ist aus der Gruppe bestehend aus Diethylether, Ethylacetat, Toluol und Hexan.

**15.** Verfahren nach einem der Ansprüche 11 bis 14, wobei Schritt (3) in einer Umgebungsatmosphäre bevorzugt bei 150 °C für 1 bis 3 Minuten ausgeführt wird.

**16.** Verwendung der Zusammensetzung nach einem der Ansprüche 1 bis 10 beim Tintenstrahldrucken.

**17.** Verwendung nach Anspruch 16, um eine optoelektronische Vorrichtung herzustellen.

**18.** Verwendung nach Anspruch 16 oder 17, um eine Solarzelle oder eine Leuchtdiode (LED) herzustellen.

**19.** Solarzelle, wobei die Zusammensetzung nach einem der Ansprüche 1 bis 10 und eine Perowskit-Vorstufen umfassende Zusammensetzung per Tintenstrahldruck aufgebracht werden.

**20.** Solarzelle, umfassend, nach Anspruch 19, in der folgenden Reihenfolge:

ein Glassubstrat (1);
eine Beschichtungsschicht (2) aus fluordotiertem Zinnoxid oder indiumdotiertem Zinnoxid;

eine dünne Schicht einer aufgesprühten TiO$_2$-Schicht (3);
eine per Tintenstrahldruck aufgebrachte TiO$_2$-Schicht (4) der Zusammensetzung nach einem der Ansprüche 1 bis 9;
eine per Tintenstrahldruck aufgebrachte Perowskit-Schicht (5);
eine per Rotationsbeschichtung aufgebrachte Lochtransportmaterialschicht (6); und
eine thermisch aufgedampfte Goldschicht (7).

**Revendications**

1.  Composition comprenant :

    (A) une source d'oxyde de titane comprenant :
    (A1) des particules de TiO$_2$ ; et
    (B) un mélange de solvants comprenant :

    (B1) cyclopentanol, cyclohexanol ou un mélange de ceux-ci ;
    (B2) polyéthylène glycol, polypropylène glycol, poly(alcool vinylique), poly(vinyl)pyrrolidone, éthylcellulose ou un mélange de ceux-ci ; et
    (B3) un N,N-dialkylamide, un alkylsulfoxyde ou un mélange de ceux-ci.

2.  Composition selon la revendication 1, dans laquelle la taille de particule de (A1) est de 10 nm ou plus et 50 nm ou moins, de préférence 20 nm ou plus et 40 nm ou moins et encore mieux 25 nm ou plus et 35 nm ou moins, et bien mieux encore d'environ 30 nm, dans laquelle la taille de particule est mesurée par microscopie électronique à balayage (SEM).

3.  Composition selon la revendication 1 ou 2, dans laquelle la (A1) est de l'anatase mésoporeuse.

4.  Composition selon l'une quelconque des revendications 1 à 3, dans laquelle (B2) est le polyéthylène glycol et/ou polypropylène glycol.

5.  Composition selon l'une quelconque des revendications 1 à 4, dans laquelle (B2) présente une masse moléculaire de 200 Da ou plus et 1 000 Da ou moins, de préférence 250 Da ou plus et 600 Da ou moins, et encore mieux 300 Da ou plus et 500 Da ou moins.

6.  Composition selon l'une quelconque des revendications 1 à 5, dans laquelle (B2) est PEG-400.

7.  Composition selon l'une quelconque des revendications 1 à 6, dans laquelle (B3) est choisi dans le groupe consistant en N,N-diméthyl-formamide, N,N-diéthylformamide, N,N-diméthylacétamide et N,N-diéthylacétamide, lactames, tels que N-alkyl lactames et alkylsulfoxydes, tels que diméthylsulfoxydes, éthylméthylsulfoxyde, diéthylsulfoxyde et mélanges de ceux-ci, et de préférence N,N-diméthylformamide.

8.  Composition selon l'une quelconque des revendications 1 à 7, dans laquelle la composition comprend de plus un ou plusieurs précurseurs de TiO$_2$ (A2), de préférence choisis dans un groupe consistant en bis(acétylacétone) diisopropoxyde de titane, isopropoxyde de titane, éthoxyde de titane, tétrachlorure bis tétrahydrofurane de titane titane, et encore mieux bis(acétylacétone) diisopropoxyde de titane.

9.  Composition selon l'une quelconque des revendications 1 à 8, dans laquelle, pour la quantité de masse totale de la composition pour un total de 100 % en masse, la quantité de masse de (A1) est de 0,323 % à 0,418 % :

$$0{,}323 \leq \frac{\text{masse de (A1)}}{\text{masse totale de la composition}} * 100 \leq 0{,}418$$

10. Composition selon l'une quelconque des revendications 1 à 9, dans laquelle, pour la quantité totale de (B1), (B2) et (B3) ajoutés pour un total de 100 % en volume, la quantité de (B1) est de 58 % en volume ou plus et 68 % en volume ou moins, la quantité de (B2) est de 16 % en volume ou plus et 26 % en volume ou moins, et la quantité de (B3) est de 11 % en volume ou plus et 21 % en volume ou moins :

$$58 \leq \frac{volume\ de\ (B1)}{somme\ du\ volume\ de\ (B1),(B2)\ et\ (B3)} * 100 \leq 68$$

$$16 \leq \frac{volume\ de\ (B2)}{somme\ du\ volume\ de\ (B1),(B2)\ et\ (B3)} * 100 \leq 26$$

$$11 \leq \frac{volume\ de\ (B3)}{somme\ du\ volume\ de\ (B1),(B2)\ et\ (B3)} * 100 \leq 21$$

de préférence, la quantité de (B1) est de 61 % en volume ou plus et 65 % en volume ou moins, la quantité de (B2) est de 19 % en volume ou plus et 23 % en volume ou moins, et la quantité de (B3) est de 14 % en volume ou plus et 18 % en volume ou moins :

$$61 \leq \frac{(B1)}{somme\ du\ volume\ de\ (B1),(B2)\ et\ (B3)} * 100 \leq 65$$

$$19 \leq \frac{(B2)}{somme\ du\ volume\ de\ (B1),(B2)\ et\ (B3)} * 100 \leq 23$$

$$14 \leq \frac{(B3)}{somme\ du\ volume\ de\ (B1),(B2)\ et\ (B3)} * 100 \leq 18$$

**11.** Procédé d'impression par jet d'encre comprenant les étapes suivantes :

(1) impression de la composition selon l'une quelconque des revendications 1 à 10 sur un substrat pour obtenir un film imprimé ;
(2) éventuellement, immersion du film imprimé obtenu dans l'étape (1) dans un anti-solvant, pour obtenir un film immergé ; et
(3) recuit du film immergé obtenu dans l'étape (2).

**12.** Procédé d'impression par jet d'encre selon la revendication 11, comprenant de plus l'étape (4) suivante après l'étape (3) :
(4) dépôt par pulvérisation d'une solution comprenant des précurseurs de pérovskite choisis dans le groupe consistant en MAI, $PbI_2$, MABr, $PbBr_2$, MACl, $PbCl_2$, PEAI, PEABr, PEACl, CsI, $SrCl_2$, $CaCl_2$, KI, CsBr, CsCl, NaCl, NaI, GUAI, GUABr, GUACl, FAI, FABr, FACl, dans lequel MA représente le méthylammonium, PEA le phényléthylammonium, GUA le guanidinium, et FA le formamidinium.

**13.** Procédé selon la revendication 11 ou 12, dans lequel le substrat est choisi dans le groupe consistant en semi-conducteurs d'oxyde de métaux tel que ZnO, $TiO_2$, $SnO_2$, ZnO dopé par Al (AZO), $NiO_x$, oxyde de vanadium, $SiO_2$, $Al_2O_3$, Si, graphène ; et d'autres chalcogénures de métal de transition 2D, tels que $MoS_2$, $MoSe_2$, $VS_2$, $FeS_2$ ; du verre revêtu avec de l'oxyde d'étain dopé au fluor, verre avec surfaces de dioxyde de titane sur verre.

**14.** Procédé selon l'une quelconque des revendications 11 à 13, dans lequel l'anti-solvant est choisi dans le groupe consistant en diéthyléther, acétate d'éthyle, toluène, et hexane.

**15.** Procédé selon l'une quelconque des revendications 11 à 14, dans lequel l'étape (3) est réalisée dans une atmosphère ambiante, de préférence à 150 °C, pendant de 1 à 3 minutes.

**16.** Utilisation de la composition selon l'une quelconque des revendications 1 à 10 dans une impression par jet d'encre.

**17.** Utilisation selon la revendication 16, afin de produire un dispositif optoélectronique.

**18.** Utilisation selon la revendication 16 ou 17, afin de produire une cellule solaire ou une diode électroluminescente (LED).

**19.** Cellule solaire dans laquelle la composition selon l'une quelconque des revendications 1 à 10 et une composition comprenant des précurseurs de pérovskite sont imprimées par jet d'encre.

**20.** Cellule solaire comprenant, selon la revendication 19, dans l'ordre suivant :

- un substrat en verre (1) ;
- une couche de revêtement (2) d'oxyde d'étain dopé au fluor ou d'oxyde d'étain dopé à l'indium ;
- une mince couche de couche de $TiO_2$ déposée par pulvérisation (3) ;
- une couche de $TiO_2$ imprimée par jet d'encre (4) de la composition selon l'une quelconque des revendications 1 à 9;
- une couche de pérovskite imprimée par jet d'encre (5) ;
- une couche de matière de transport de trou déposée par centrifugation (6) ; et
- une couche d'or thermiquement évaporé (7).

**Figure 1**

**Figure 2**

**Figure 3**

**Figure 4**

**EP 3 914 658 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20120111409 A
- US 20160104843 A

- CN 108922970

**Non-patent literature cited in the description**

- *Energy Technol,* 2015, vol. 3, 866-870

- *J. Colloid and interface Science,* 2016, vol. 465, 208-214